# FASCICULE DE BREVET EUROPEEN

(11) **EP 1 188 187 B1**
(45) Date de publication et mention de la délivrance du brevet: **23.09.2009**
(21) Numéro de dépôt: 00935256.8
(22) Date de dépôt: 25.05.2000
(51) Int. Cl.: H01L 27/146, G01T 1/24

(54) **DETECTEUR A SEMI-CONDUCTEUR POUR LA DETECTION DE RAYONNEMENTS IONISANTS**
HALBLEITERDETEKTOR FÜR IONISIERENDE STRAHLUNG
SEMICONDUCTOR DETECTOR FOR DETECTING IONIZING RADIATION

(30) Priorité: 25.05.1999 FR 9906568
(43) Date de publication de la demande: 20.03.2002
(73) Titulaire: COMMISSARIAT A L'ENERGIE ATOMIQUE, 75015 Paris (FR)
(72) Inventeur: MONNET, Olivier, F-38210 Tullins (FR); BONNEFOY, Jean-Paul, F-38100 Grenoble (FR); MESTAIS, Corinne, F-38660 La Terrasse (FR); SAUVAGE, Francis, F-38430 Moirans (FR)
(74) Mandataire: Audier, Philippe André
(86) Numéro de dépôt international: PCT/FR2000/001417
(87) Numéro de publication internationale: WO 2000/072381

(56) Documents cités:
- EP-A- 0 287 197
- US-A- 5 786 597
- PATENT ABSTRACTS OF JAPAN vol. 006, no. 111 (E-114), 22 juin 1982 (1982-06-22) & JP 57 039585 A (TOSHIBA CORP), 4 mars 1982 (1982-03-04)
- M. ARQUES ET AL.: "A Basic Component for ISGRI, the CdTe Gamma Camera on Board the INTEGRAL Satellite" 1998 IEEE NUCLEAR SCIENCE SYMPOSIUM CONFERENCE RECORDS, vol. 1, 8 - 14 novembre 1998, pages 666-671, XP000861763 Toronto, Canada cité dans la demande
- PATENT ABSTRACTS OF JAPAN vol. 006, no. 111 (E-114), 22 juin 1982 (1982-06-22) -& JP 57 039585 A (TOSHIBA CORP), 4 mars 1982 (1982-03-04)

## Description

### Domaine technique et art antérieur

L'invention concerne un détecteur à semi-conducteur pour la détection de rayonnements ionisants (gamma, X, etc.).

Plus particulièrement, l'invention concerne un dispositif d'amenée de tension de polarisation de détecteur à semi-conducteur pour la détection de rayonnements ionisants (gamma, X, etc.).

L'invention s'applique plus particulièrement dans des domaines où les rayonnements détectés sont des rayonnements de haute énergie tels que, par exemple, l'astrophysique ou encore la médecine nucléaire.

Un détecteur à semi-conducteur se présente sous la forme d'une mosaïque de détecteurs élémentaires, ou pixels, assemblés pour constituer au moins un bloc détecteur.

Chaque pixel détecteur est constitué d'un élément semi-conducteur, par exemple du CdZnTe, compris entre deux armatures.

Un pixel détecteur convertit l'énergie des photons qu'il reçoit en porteurs de charges. La collecte des porteurs de charges s'effectue à l'aide d'une tension de polarisation appliquée aux armatures du pixel détecteur.

Les pixels détecteurs sont collés sur un substrat électronique qui comprend une résistance de polarisation, une capacité de couplage et un préamplificateur de charges. L'amplification et la mise en forme du signal sont réalisées par un circuit électronique de mesure.

Afin d'être plus efficace à la détection de rayonnements de haute énergie, il est nécessaire d'épaissir l'élément semi-conducteur situé entre les armatures des pixels détecteurs.

La polarisation d'un détecteur à semi-conducteur plus épais entraîne l'utilisation d'une tension de polarisation plus élevée. La tension peut alors atteindre plusieurs centaines de volts.

Dans le cas, par exemple, de l'imageur ISGRI (ISGRI pour "Integral Soft Gamma Ray Imager) embarqué dans le satellite INTEGRAL (INTEGRAL pour "INTErnational Gamma-Ray Astrophysics Laboratory"), la tension de polarisation est typiquement égale à 200V.

Dans le cas de l'imageur PEGASE (PEGASE pour "Projet d'Etude de Gamma caméra A SEmi-conducteur"), les tensions de polarisation sont comprises entre 500V et 1000V.

Le détecteur à semi-conducteur de l'imageur ISGRI est décrit dans le document intitulé "A Basic Component for ISGRI, the CdTe Gamma Camera on Board the INTEGRAL Satellite", M. Arques et al., paru dans "Paper presented at Toronto 1998 IEEE NSS conference".

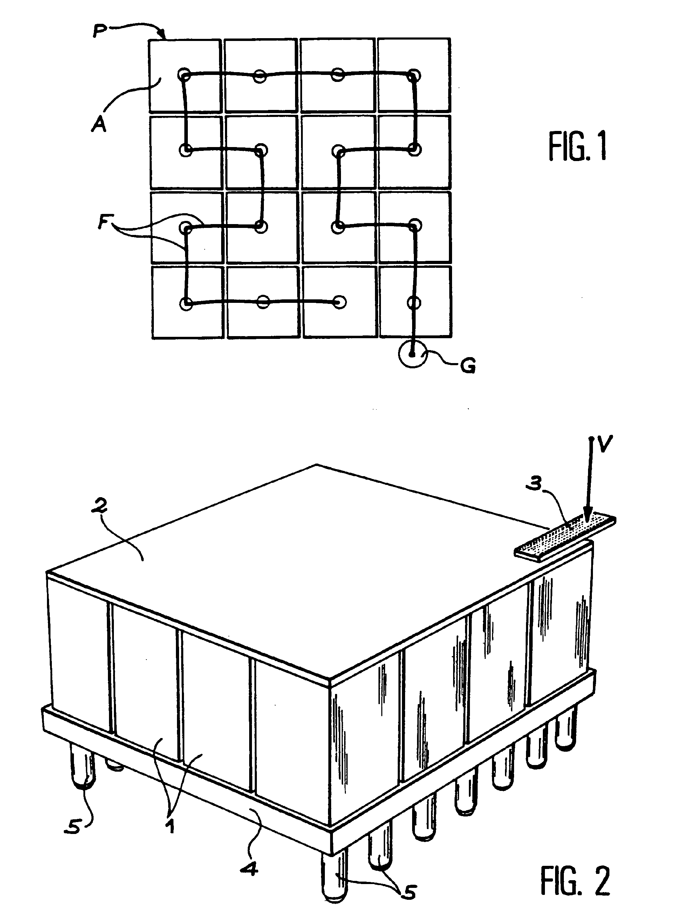

Un bloc détecteur selon l'imageur ISGRI est décrit en figure 1.

La figure 1 représente une vue de dessus d'un bloc de pixels détecteurs selon l'imageur ISGRI. Le bloc de pixels détecteurs est constitué de 16 pixels détecteurs P rassemblés côte à côte de façon à constituer une matrice 4x4. Chaque pixel détecteur P présente une armature A sur sa face supérieure. L'ensemble des armatures A des pixels détecteurs P définit un plan détecteur exposé aux rayonnements à détecter.

La tension de polarisation est amenée sur les armatures A à l'aide d'un fil F. Le fil F est plié et collé afin de distribuer la tension de polarisation à l'ensemble des armatures A. Le pliage et le collage du fil F sont des opérations délicates et coûteuses.

La tension de polarisation provient d'un dispositif d'alimentation externe au détecteur (non représenté sur la figure) via un fil courant sur un substrat électronique situé en face arrière du bloc détecteur. Il est alors nécessaire de faire passer le fil le long du bloc détecteur, dans une direction sensiblement perpendiculaire au plan détecteur. Afin d'éviter tout faux contact, le fil F est enrobé d'une gaine G dans la zone où il relie la face arrière et la face avant du bloc détecteur.

La gaine G est constituée d'un isolant dont l'épaisseur est d'autant plus grande que la tension que transmet le fil est élevée.

Quand plusieurs blocs détecteurs sont rassemblés côte à côte pour former un ensemble unique de détection, l'encombrement de la gaine G de chaque bloc détecteur crée une zone morte de non détection dans le plan détecteur. Cette zone morte de non détection est d'autant plus importante que la tension de polarisation est élevée. Ceci présente un inconvénient.

Comme cela est mentionné ci-dessus, la tension de polarisation transite par le substrat électronique situé en face arrière du bloc détecteur. La face arrière du bloc détecteur est également la zone où sont présents les signaux utiles issus de la détection du rayonnement et l'ensemble des signaux électriques nécessaires au fonctionnement du circuit d'électronique de mesure.

Ainsi, des précautions de voisinage s'avèrent-elles nécessaires entre la tension de polarisation et les autres signaux. Ces précautions s'avèrent particulièrement importantes à mettre en oeuvre lorsque la tension de polarisation a une valeur élevée et lorsque les signaux utiles sont, par exemple, de quelques Femtocoulombs. Il est alors nécessaire d'éloigner la tension de polarisation des signaux utiles, ce qui conduit à réduire la surface utile du substrat électronique situé en face arrière. Cette réduction de surface utile peut même aller jusqu'à l'impossibilité de concevoir un circuit fonctionnant dans de bonnes conditions de fiabilité.

Le document intitulé "Réalisation et évaluation des performances d'une caméra miniature péropératoire CDTE", Bedoui H. et al., paru dans Innov. Techn. Biol. Med., vol. 19, n°1, 1998 divulgue également un détecteur à semi-conducteur de l'art connu. Les pixels détecteurs sont également regroupés en blocs détecteurs. Les documents US 5786597 et JP 57039585 décrivent d'autres examples des pixels détecteurs assemblés en blocs.

Chaque pixel détecteur d'un bloc détecteur est individuellement polarisé par un fil provenant de la périphérie du plan détecteur. Une zone morte de non détection apparaît alors là où passent les fils. Cette solution limite donc également la zone de détection et rend impossible la réalisation de grandes surfaces de détection. Il est par exemple impossible de réaliser des surfaces de détection de 200x200 mm² telles que celles envisagées pour PEGASE.

### Exposé de l'invention

L'invention ne présente pas les inconvénients mentionnés ci-dessus.

En effet, l'invention concerne un détecteur à semi-conducteur comme définit dans la revendication 1.

Un avantage de l'invention est de réaliser un détecteur à semi-conducteur quasiment dépourvu de zone de non détection.

### Brève description des figures

D'autres caractéristiques et avantages de l'invention apparaîtront à la lecture d'un mode de réalisation préférentiel de l'invention fait en référence aux figures ci-annexées parmi lesquelles :
- la figure 1 représente un bloc de pixels détecteurs selon l'art antérieur,
- La figure 2 représente un bloc de pixels détecteurs selon l'invention,
- Les figures 3A, 3B, 3C, 3D représentent quatre variantes d'un ensemble de deux blocs de pixels détecteurs selon l'invention,
- la figure 4 représente une matrice de blocs détecteurs selon un mode de réalisation particulier de l'invention.

Sur toutes les figures, les mêmes repères désignent les mêmes éléments.

### Description détaillée de modes de mise en oeuvre de l'invention

La figure 1 a été décrite précédemment. Il est donc inutile d'y revenir.

La figure 2 représente un bloc de pixels détecteurs selon l'invention.

A titre d'exemple non limitatif, le bloc de pixels détecteurs est constitué de 16 pixels détecteurs élémentaires disposés côte à côte sous forme d'une matrice 4x4.

Chaque pixel détecteur élémentaire est constitué d'un élément semi-conducteur 1 ayant une première face recouverte d'une première armature (non représentée sur la figure) et une deuxième face recouverte d'une deuxième armature (non représentée sur la figure).

Les premières armatures des différents pixels détecteurs sont recouvertes d'une même structure conductrice plane 2. La structure conductrice plane peut être, par exemple, un circuit de type Mylar® recouvert d'un dépôt de cuivre.

Une connexion électrique 3 permet de relier la structure conductrice 2 à une tension de polarisation V. Quand la connexion électrique 3 est reliée à la tension de polarisation V , l'ensemble des premières électrodes se trouve donc polarisé à une même valeur.

Un substrat modulaire 4 contenant les circuits électriques destinés à collecter et à traiter les signaux utiles issus des pixels détecteurs recouvre l'ensemble des deuxièmes armatures des pixels détecteurs. Des connexions électriques 5 permettent l'accès aux signaux électriques utiles ainsi qu'aux signaux électriques nécessaires au fonctionnement des circuits électriques contenus dans le substrat modulaire 4.

Avantageusement, selon l'invention, la tension de polarisation V est éloignée des signaux utiles. En effet, la tension de polarisation V est uniquement distribuée du côté du plan détecteur et les signaux utiles se répartissent du côté opposé au plan détecteur. La distribution de la tension de polarisation peut alors s'effectuer par le biais d'une structure indépendante du substrat modulaire.

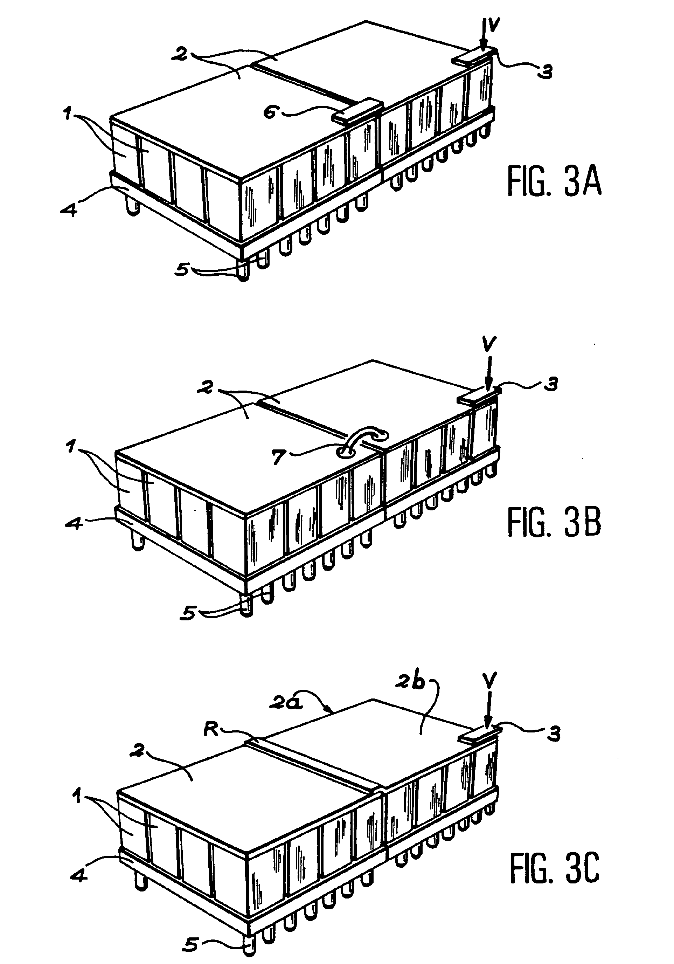

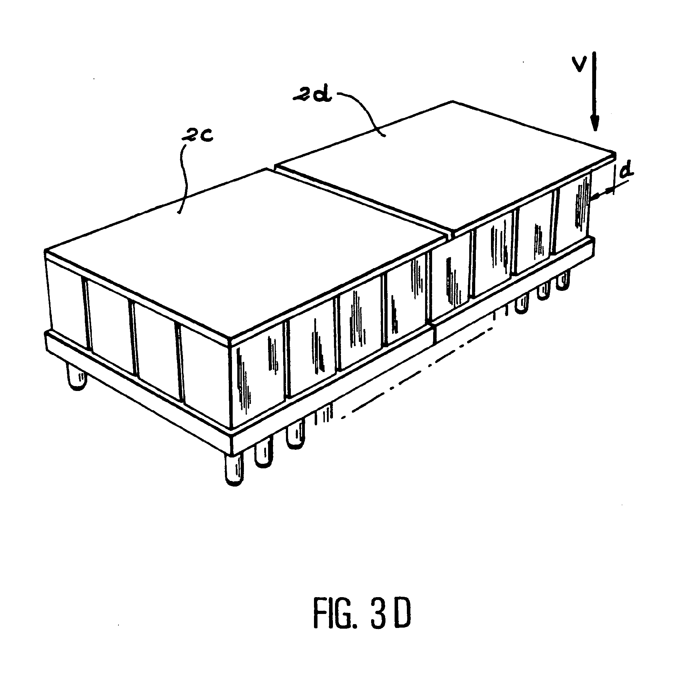

Les figures 3A, 3B, 3C, 3D représentent quatre variantes d'un ensemble de deux blocs de pixels détecteurs selon l'invention.

Selon la première variante représentée en figure 3A, les deux blocs de pixels détecteurs sont assemblés côte à côte et les structures conductrices planes 2 sont reliées par une languette conductrice 6. La tension de polarisation V est distribuée à l'ensemble des pixels détecteurs des deux blocs par l'intermédiaire d'une connexion électrique 3 reliée à la structure conductrice plane de l'un des blocs.

Selon la deuxième variante représentée en figure 3B, les plans conducteurs des deux blocs détecteurs sont reliés par un fil de câblage 7.

Selon la troisième variante représentée en figure 3C, un recouvrement R existe entre les structures conductrices qui recouvrent les premières armatures de deux blocs voisins.

Les premières armatures d'un premier bloc détecteur sont alors recouvertes par une structure conductrice plane 2 telle que mentionnée ci-dessus et les premières armatures du bloc détecteur voisin sont recouvertes par une structure conductrice 2a constituée d'une structure conductrice plane 2b et d'une zone en forme de marche d'escalier de façon à permettre le recouvrement R.

Selon la quatrième variante représentée en figure 3D, les structures conductrices planes sont décalées par rapport aux blocs détecteurs. La structure conductrice plane 2c qui recouvre les premières armatures des pixels détecteurs d'un premier bloc recouvre partiellement les pixels détecteurs du bloc voisin.

La structure conductrice plane 2c recouvre, par ailleurs, toutes les premières armatures de l'un des deux blocs détecteurs. Les premières armatures de l'autre bloc détecteur sont alors recouvertes par une structure conductrice plane 2d qui déborde du bloc détecteur sur une distance d. La partie de la structure conductrice plane 2d qui déborde du bloc détecteur sur la distance d constitue alors un élément de connexion de l'ensemble des deux blocs détecteurs à la tension de polarisation V.

Quelle que soit la variante mise en oeuvre, l'association de deux blocs de pixels détecteurs telle que décrite ci-dessus présente l'avantage déjà mentionné pour un seul bloc, à savoir une distribution de la tension de polarisation qui s'effectue par le biais d'une structure indépendante des substrats modulaires. La tension de polarisation est distribuée du côté des plans détecteurs et les signaux utiles sont répartis du côté opposé au plan détecteur.

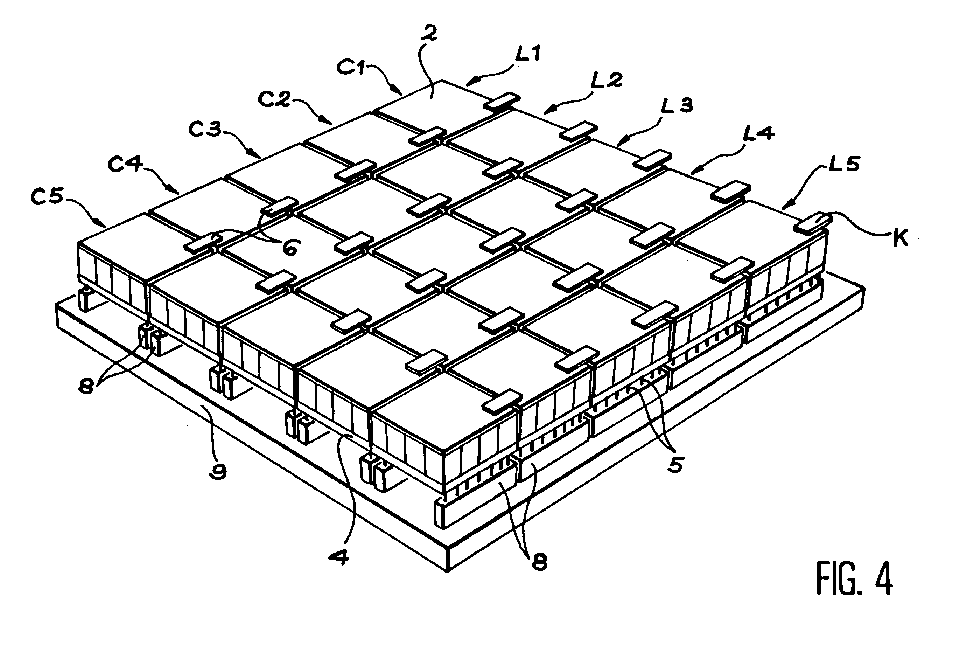

Les figures 3A, 3B, 3C et 3D représentent un détecteur à semi-conducteur fait de l'association de deux blocs de pixels détecteurs. De façon plus générale, l'invention concerne, cependant, également un détecteur à semi-conducteur fait de l'association d'un nombre de blocs de pixels détecteurs supérieur à 2, comme cela va être décrit, à titre d'exemple non limitatif, en référence à la figure 4.

La figure 4 représente une matrice de blocs détecteurs selon un mode de réalisation particulier de l'invention.

La matrice de blocs détecteurs comprend 25 blocs détecteurs sous la forme d'une matrice de 5 lignes L1, L2, L3, L4, L5 et 5 colonnes C1, C2, C3, C4, C5. De façon plus générale, l'invention concerne une matrice de blocs détecteurs sous la forme d'une matrice de N lignes et M colonnes, M et N étant des entiers supérieurs ou égaux à 1.

Les structures conductrices planes 2 des blocs de pixels détecteurs d'une même ligne Lj (j=1, 2, 3, 4, 5) sont reliées entre elles par une succession de languettes conductrices 6 comme décrit en figure 3A. Selon d'autres modes de réalisation, les structures conductrices qui recouvrent les blocs détecteurs peuvent être reliées entre elles comme décrit aux figures 3B, 3C ou 3D.

Les connexions électriques 5 issues de chaque substrat modulaire 4 sont enfichées dans un élément de support 8. Les éléments de support 8 des différents blocs détecteurs sont rapportés sur une structure commune 9 permettant de regrouper en un seul bloc les différents blocs détecteurs.

Un élément de connexion électrique K situé à l'extrémité d'une ligne Lj (j=1, 2,, 3, 4, 5) permet de relier à une tension Vj les différentes structures conductrices 2 des blocs détecteurs d'une même ligne Lj.

Avantageusement, selon le mode de réalisation de la figure 4, chaque ligne Lj (j=1, 2, 3, 4, 5) de blocs détecteurs peut alors être polarisée avec une tension d'alimentation qui lui est propre. Plusieurs lignes de blocs détecteurs peuvent cependant être reliées à une même tension d'alimentation.

L'invention permet de réaliser des matrices de blocs détecteurs de grandes dimensions, par exemple 200 x 200 mm², pour lesquelles la structure d'alimentation de la tension de polarisation est éloignée des substrats modulaires 4 par lesquels transitent les signaux détectés.

Avantageusement, une matrice de blocs détecteurs selon l'invention ne présente aucune zone morte de non détection.

Un autre avantage de l'invention est de permettre un montage/démontage facile des blocs détecteurs. En cas de panne d'un bloc détecteur, par exemple, il est en effet très facile de substituer le bloc détecteur défectueux par un bloc détecteur fonctionnant correctement.

## Revendications

1. Détecteur à semi-conducteur pour la détection de rayonnements ionisants comprenant des pixels détecteurs élémentaires assemblés côte à côte sur un substrat (4), chaque pixel détecteur élémentaire étant constitué d'un élément semi-conducteur (1) ayant une première face recouverte d'une première armature et une deuxième face recouverte d'une deuxième armature, les pixels détecteurs élémentaires étant assemblés côte à côte de façon que les premières armatures définissent un plan détecteur, **caractérisé en ce que** les pixels détecteurs élémentaires sont assemblés sous forme d'une pluralité de blocs détecteurs placés côte à côte, les premières armatures des pixels détecteurs de chaque bloc détecteur étant reliées électriquement par une structure conductrice plane (2) qui les recouvre, ladite structure conductrice plane (2) étant propre audit bloc, les deuxièmes armatures des pixels détecteurs de chaque bloc étant rapportées sur un substrat (4) propre audit bloc, la structure conductrice plane (2) qui recouvre les premières armatures d'un premier bloc détecteur étant reliée par une connexion électrique (6, 7) à la structure conductrice plane (2) qui recouvre les premières armatures d'au moins un deuxième bloc détecteur voisin du premier bloc détecteur, les blocs détecteurs de la pluralité de bloc détecteurs étant rapportés sur une structure commune (9).

2. Détecteur à semi-conducteur selon la revendication 1, **caractérisé en ce que** le substrat (4) propre à chaque bloc est un substrat modulaire contenant des circuits électriques pour collecter et traiter des signaux issus des pixels détecteurs élémentaires du bloc.

3. Détecteur à semi-conducteur selon la revendication 1 ou 2, **caractérisé en ce que** la connexion électrique est une languette (6), ou un fil de liaison (7), ou un recouvrement (R) de l'une des structures conductrices planes (2) par une structure conductrice plane (2a) voisine.

4. Détecteur à semi-conducteur selon la revendication 1 ou 2, **caractérisé en ce que** la structure conductrice plane (2c) qui recouvre les premières armatures des pixels détecteurs élémentaires d'un premier bloc détecteur recouvre partiellement les pixels détecteurs élémentaires d'au moins un bloc détecteur voisin.

5. Détecteur à semi-conducteur selon l'une quelconque des revendications précédentes, **caractérisé en ce que** chaque bloc détecteur comprend des connexions électriques (5) permettant l'accès aux signaux électriques utiles issus des pixels détecteurs élémentaires du bloc, les connexions (5) électriques de chaque bloc détecteur étant enfichées dans un élément de support (8) propre au bloc, les éléments de support (8) des différents blocs détecteurs étant rapportés sur la structure commune (9).

6. Détecteur à semi-conducteur selon l'une quelconque des revendications précédentes, **caractérisé en ce qu'**il est structuré sous la forme d'une matrice de N lignes de M blocs, les structures conductrices planes (2) qui relient un premier bloc détecteur et au moins un deuxième bloc détecteur voisin du premier bloc détecteur reliant deux blocs détecteurs voisins d'une même ligne, une structure conductrice plane (2) d'un bloc détecteur situé à une extrémité d'une ligne étant reliée à un élément de connexion électrique (K) pour appliquer une tension.

7. Détecteur à semi-conducteur selon l'une quelconque des revendications précédentes, **caractérisé en ce que** la structure conductrice plane (2) est un circuit de type Mylar® recouvert d'un dépôt de cuivre.

## Claims

1. Semiconductor detector for detection of ionizing radiation comprising elementary detector pixels assembled side by side on a substrate (4), each elementary detector pixel being composed of a semiconducting element (1) with a first face covered with a first armature and a second face covered with a second armature, the elementary detector pixels being assembled side by side such that the first armatures define a detector plane, **characterized in that** the elementary detector pixels are assembled in the form of a plurality of detector blocks placed side by side, the first armatures of the detector pixels of each block being electrically connected by a plane conducting structure (2) that covers them, said plane conducting structure being peculiar to said block, the second armatures of the detector pixels of each block being placed on a substrate (4) peculiar to said block, the plane conducting structure (2) that covers the first armatures of a first detector block being connected by means of an electrical connection to the plane conducting structure (2) that covers the first armatures of at least a second detector block adjacent to the first detector block, the detector blocks of the plurality of detector blocks being placed on a common structure (9).

2. Semiconductor detector according to claim 1, **characterized in that** the substrate (4) peculiar to each block is a modular substrate containing electrical circuits to collect and process signals output from elementary detector pixels in the block.

3. Semiconductor detector according to claim 1 or 2, **characterized in that** the electrical connection is a tab (6) or a connecting wire (7) or an overlap (R) of one of the conducting structures (2) by an adjacent conducting structure (2a).

4. Semiconductor detector according to claim 1 or 2, **characterized in that** the plane conducting structure that covers the first armatures of the elementary detector pixels of a first detector block covers partially the elementary detector pixel of a least an adjacent detector block.

5. Semiconductor detector according to any of the preceding claims, **characterized in that** each detector block comprises electrical connections (5) providing access to useful electrical signals output from elementary detector pixels of the block, the electrical connections (5) of each detector block being plugged into a support element (8) peculiar to the block, the support element (8) of the various detector blocks being placed on the common structure (9).

6. Semiconductor detector according to any of the preceding claims, **characterized in that** it is structured in the form of a matrix of N rows of M blocks, the plane conducting structures (2) that connect a first detector block with at least a second detector block adjacent to the first detector block connecting two adjacent detector blocks of a same row, a plane conducting structure (2) of a detector block located at the end of a row being led to an electrical connection element (K) to apply a voltage.

7. Semiconductor detector according to any one of the previous claims, **characterized in that** the plane conducting structure (2) is a Mylar^{®} type circuit covered by a copper deposit.

## Patentansprüche

1. Halbleiterdetektor für die Detektion von ionisierender Strahlung, umfassend Elementarpixeldetektoren, Seite an Seite, auf einem Substrat (4), wobei jeder Elementarpixeldetektor durch ein Halbleiterelement (1) gebildet wird, mit einer ersten Seite, bedeckt von einer ersten Armierung, und einer zweiten Seite, bedeckt von einer zweiten Armierung, wobei die Elementarpixeldetektoren Seite an Seite so zusammengebaut werden, dass die ersten Armierungen eine Detektorebene definieren,
**dadurch gekennzeichnet, dass** die Elementarpixeldetektoren zusammengebaut sind in Form einer Vielzahl von Seite an Seite angeordneten Detektorblöcken, wobei die ersten Armierungen der Pixeldetektoren jedes Detektorblocks elektrisch verbunden sind durch eine sie bedeckende elektrisch leitfähige plane Struktur (2), wobei die genannte leitfähige plane Struktur (2) dem genannten Block eigen ist, die zweiten Armierungen der Pixeldetektoren jedes Blocks auf einem dem genannten Block eigenen Substrat (4) realisiert sind, die leitfähige plane Struktur (2), welche die ersten Armierungen eines ersten Detektorblocks bedeckt, durch eine elektrische Verbindung (6, 7) mit der leitfähigen planen Struktur (2) verbunden ist, welche die ersten Armierungen wenigstens eines dem ersten Detektorblock benachbarten zweiten Detektorenblocks bedeckt, wobei die Detektorblöcke der Vielzahl von Detektorblöcken sich auf einer gemeinsamen Struktur (9) befinden.

2. Halbleiterdetektor nach Anspruch 1, **dadurch gekennzeichnet, dass** das jedem Block eigene Substrat (4) ein Modulsubstrat mit elektrischen Schaltungen zur Verarbeitung der von den Elementarpixeldetektoren des Blocks stammenden Signale ist.

3. Halbleiterdetektor nach Anspruch 1 oder 2, **dadurch gekennzeichnet, dass** die elektrische Verbindung eine Zunge (6) oder ein Verbindungsdraht (7) oder eine Überlappung von einer der leitfähigen planen Strukturen (2) durch eine benachbarte leitfähige plane Struktur (2a) ist.

4. Halbleiterdetektor nach Anspruch 1 oder 2, **dadurch gekennzeichnet, dass** die leitfähige plane Struktur (2c), welche die ersten Armierungen der Elementarpixeldetektoren eines ersten Detektorenblocks bedeckt, die Elementarpixeldetektoren von wenigstens einem benachbarten Detektorenblock partiell bedeckt.

5. Halbleiterdetektor nach einem der vorangehenden Ansprüche, **dadurch gekennzeichnet, dass** jeder Detektorblock elektrische Anschlüsse (5) umfasst, die ermöglichen, auf die von den Elementarpixeldetektoren des Blocks stammenden elektrischen Nutzsignale zuzugreifen, wobei die elektrischen Anschlüsse (5) jedes Detektorblocks eingesteckt sind in ein für den Block vorgesehenes Trägerelement (8), wobei die Trägerelemente (8) der verschiedenen Detektorblöcke auf die gemeinsamen Struktur (9) montiert sind.

6. Halbleiterdetektor nach einem der vorangehenden Ansprüche, **dadurch gekennzeichnet, dass** er strukturiert ist in Form einer Matrix von N Zeilen mit M Blöcken, wobei die einen ersten Detektorblock mit wenigstens einem benachbarten zweiten Detektorblock verbindenden leitfähigen planen Strukturen (2) zwei benachbarte Detektorenblöcke einer selben Zeile verbinden und eine leitfähige plane Struktur (2) eines am Ende einer Zeile befindlichen Detektorblocks verbunden ist mit einem elektrischen Verbindungselement (K), um eine Spannung anzulegen.

7. Halbleiterdetektor nach einem der vorangehenden Ansprüche, **dadurch gekennzeichnet, dass** die leitfähige plane Struktur (2) ein Strompfad vom Typ Kupferabscheidung auf Mylar® ist.
